# FASCICULE DE BREVET EUROPEEN

(11) **EP 0 821 488 B1**
(45) Date de publication et mention de la délivrance du brevet: **23.10.2002**
(21) Numéro de dépôt: 97202258.6
(22) Date de dépôt: 18.07.1997
(51) Int. Cl.: H03L 7/095

(54) **Dispositif de sélection de fréquence muni d'un détecteur de verrouillage**
Einrichtung zur Frequenzselektion mit einem Verriegelungsdetektor
Device for frequency selection comprising a lock detector

(30) Priorité: 24.07.1996 FR 9609308
(43) Date de publication de la demande: 28.01.1998
(73) Titulaire: Koninklijke Philips Electronics N.V., 5621 BA Eindhoven (NL)
(72) Inventeur: Vigne, Alain, Société Civile S.P.I.D., 75008 Paris (FR)
(74) Mandataire: Charpail, François

(56) Documents cités:
- EP-A- 0 124 332
- EP-A- 0 637 138
- EP-A- 0 746 111
- US-A- 5 220 295
- US-A- 5 256 989

## Description

La présente invention concerne un dispositif de sélection de fréquence présentant une première entrée destinée à recevoir un signal radio-électrique dont la fréquence est appelée fréquence radio, ce signal radio-électrique étant sélectionné au sein d'un ensemble de signaux dont les fréquences sont situées dans une gamme donnée, dispositif présentant une deuxième entrée destinée à recevoir un signal dit de commande définissant la fréquence du signal radio-électrique à sélectionner, dispositif présentant une première sortie destinée à délivrer un signal dont la fréquence, dite fréquence intermédiaire, est fixée, dispositif présentant une deuxième sortie destinée à délivrer un signal indiquant que la fréquence radio correspond à la fréquence définie par le signal de commande, dispositif comportant :
. un oscillateur présentant une entrée de réglage destinée à recevoir un signal dit de réglage, et une sortie destinée à délivrer un signal dont la fréquence dépend de la valeur du signal de réglage,
. un mélangeur présentant une première entrée, formant la première entrée du dispositif, destinée à recevoir le signal radio-électrique, une deuxième entrée reliée à la sortie de l'oscillateur, et une sortie, formant la première sortie du dispositif, destinée à délivrer un signal dont la fréquence est égale à la différence entre la fréquence du signal reçu sur la première entrée et celle du signal reçu sur la deuxième entrée,
. un diviseur de fréquence présentant une première entrée reliée à la sortie de l'oscillateur, une deuxième entrée formant la deuxième entrée du dispositif, et une sortie destinée à délivrer un signal dont la fréquence est égale à la fréquence du signal reçu sur la première entrée, divisée par un nombre défini par le signal de commande reçu sur la deuxième entrée,
. un détecteur de phase, présentant une première entrée destinée à recevoir un signal dit de référence dont la fréquence est fixe, une deuxième entrée reliée à la sortie du diviseur de fréquence, et une sortie reliée à l'entrée de l'oscillateur.

De tels dispositifs sont couramment utilisés dans des unités de réception incluses dans des téléviseurs ou des radiotéléphones. Dans ces dispositifs, le détecteur de phase a pour fonction de synchroniser les signaux qu'il reçoit sur ses deux entrées. S'il ne peut y parvenir, il délivre un signal de réglage à l'oscillateur, de manière à corriger la fréquence du signal de sortie de celui-ci. Lorsque la fréquence du signal de sortie de l'oscillateur permet de sélectionner le signal radio-électrique dont la fréquence correspond à la fréquence radio requise qui est définie par le signal de commande, situation que l'on appelle "verrouillage", le signal de sortie du diviseur de fréquence est en phase avec le signal de référence, et le détecteur de phase ne délivre plus de signal de réglage à l'oscillateur. Dans la plupart des dispositifs de sélection de fréquence existants, cette absence de signal de réglage est détectée et indique le verrouillage, comme dans la demande EP-A-0 124 332.

Le signal de réglage est généré de manière à répondre à certains impératifs. Il est en effet le plus souvent destiné à mettre en route des pompes de charge qui permettent de modifier la polarisation de certains éléments de l'oscillateur. La forme particulière du signal de réglage qui résulte de ces impératifs ne permet pas une détection précise du verrouillage.

La présente invention a pour but de remédier, dans une large mesure, à cette imprécision, en proposant un dispositif de sélection de fréquence dans lequel le synchronisme entre le signal de sortie du diviseur de fréquence et le signal de référence est détecté et indique le verrouillage.

En effet, un dispositif de sélection de fréquence selon l'invention est caractérisé en ce qu'il comporte des moyens pour générer un signal, dit signal fenêtre, actif pendant certains intervalles de temps, englobant chacun un front actif du signal de sortie du diviseur de fréquence, et une bascule mémoire munie d'une entrée de données, d'une entrée d'horloge et d'une sortie de données, l'entrée de données étant destinée à recevoir le signal fenêtre, l'entrée d'horloge étant destinée à recevoir le signal de référence, et la sortie de données formant la deuxième sortie du dispositif.

Lorsque le signal de sortie du diviseur de fréquence et le signal de référence sont synchrones, c'est-à-dire en situation de verrouillage, le signal fenêtre encadre les fronts actifs du signal de référence. La sortie de la bascule mémoire est donc placée au niveau actif, signalant ainsi le verrouillage.

Une variante de l'invention immunise un tel dispositif de sélection de fréquence de situations dans lesquelles un front actif du signal de référence surviendrait de manière fortuite pendant un intervalle de temps où le signal fenêtre serait actif, sans que le dispositif ne soit pour autant en situation de verrouillage.

Dans une telle variante, un dispositif de sélection de fréquence tel que décrit ci-dessus est caractérisé en ce qu'il comporte un filtre numérique passe-bas inséré entre la sortie de données de la bascule mémoire et la deuxième sortie du dispositif.

Dans un mode de réalisation particulier de cette variante, ce dispositif de sélection de fréquence est caractérisé en ce que le filtre numérique comporte :
. un compteur modulo M présentant une entrée d'autorisation de comptage/initialisation reliée à la sortie de la bascule mémoire, une entrée d'horloge destinée à recevoir le signal de référence, et P sorties, avec M=2^{P}, un niveau actif sur l'entrée d'autorisation de comptage/initialisation autorisant le compteur à compter, un niveau inactif plaçant au niveau inactif chacune des sorties du compteur,
. un module dit de détection, présentant P entrées reliées aux P sorties du compteur, et une sortie, formant la deuxième sortie du dispositif, destinée à délivrer un signal qui est placé au niveau actif lorsque toutes les sorties du compteur sont au niveau actif, et maintenu à ce niveau jusqu'à ce que le compteur reçoive un niveau inactif sur son entrée d'autorisation de comptage/initialisation.

Les modes d'obtention possibles du signal fenêtre sont multiples. Une variante de l'invention propose un mode d'obtention avantageux en ce qu'il ne nécessite pas de composants supplémentaires pour sa mise en oeuvre. Cette variante présente un dispositif de sélection de fréquence tel que décrit ci-dessus, dans lequel le diviseur de fréquence est composé de N modules, dits modules élémentaires, disposés en cascade, munis chacun d'une entrée de données, d'une sortie de données et d'une sortie d'impulsions, l'entrée du premier module élémentaire formant la première entrée du diviseur de fréquence, chaque module élémentaire étant destiné à effectuer une division de fréquence et à délivrer à sa sortie de données un signal résultant de cette division et à sa sortie d'impulsions un signal qui, durant chaque période du signal de sortie du diviseur de fréquence, est actif pendant le premier état actif du signal d'entrée et inactif sinon, dispositif caractérisé en ce que, si la sortie du i^{ème} module élémentaire, i pouvant varier de 1 à N, est sélectionnée au moyen du signal de commande reçu sur la deuxième entrée du diviseur de fréquence pour former la sortie du dit diviseur, le signal fenêtre est l'un des signaux délivrés à la sortie d'impulsions d'un des i premiers modules élémentaires.

Cette variante exploite les délais induits par la mise en cascade des modules élémentaires. En effet, le signal présent à la sortie de chaque module élémentaire présente un certain retard sur le signal présent à son entrée. Ce retard est suffisant pour que les fronts actifs du signal de sortie d'un module élémentaire se trouve encadré par le signal délivré par la sortie d'impulsions d'un des modules élémentaires qui le précèdent.

Une telle variante permet en outre la sélection par voie de multiplexage, en fonction du signal de sortie du diviseur de fréquence, de celui des signaux délivrés par les sorties d'impulsions des modules élémentaires présentant une largeur d'impulsion qui donnera la plus grande précision à la détection du verrouillage. La sélection du signal de sortie du diviseur de fréquence se faisant par exemple au moyen d'un multiplexeur commandé par le signal de commande, ce même signal de commande sélectionnera parallèlement le signal fenêtre le mieux adapté.

Une autre variante de l'invention présente un mode d'obtention du signal fenêtre dans le cas où le diviseur de fréquence présente une architecture différente de celle exposée précédemment. Cette variante concerne un dispositif de sélection de fréquence tel que décrit plus haut, dans lequel le diviseur de fréquence comporte :
. N modules dits élémentaires, chacun d'entre eux présentant une entrée de données destinée à recevoir un signal d'entrée et une sortie de données destinée à délivrer un signal dont la fréquence est K fois inférieure à celle du signal reçu sur son entrée, la sortie d'un module élémentaire étant reliée à l'entrée du module élémentaire suivant, l'entrée du premier module élémentaire formant la première entrée du diviseur de fréquence, la sortie du N^{ème} module élémentaire formant la sortie du diviseur de fréquence, chaque module présentant en outre une sortie d'impulsions destinée à délivrer un signal qui, durant chaque période du signal de sortie du diviseur de fréquence, est actif pendant le premier état actif du signal d'entrée et inactif sinon,
. un décodeur présentant une entrée formant la deuxième entrée du diviseur de fréquence, et N sorties, chacune définissant le rapport K entre la fréquence du signal d'entrée d'un module élémentaire et celle de son signal de sortie,
dispositif caractérisé en ce que le signal fenêtre est l'un des signaux délivrés par les sorties d'impulsions des modules élémentaires.

Dans un mode de réalisation particulièrement avantageux de cette variante, un tel dispositif de sélection de fréquence est caractérisé en ce qu'il comporte un multiplexeur présentant N entrées de données, une entrée de commande et une sortie de données, chacune des N entrées de données étant reliée à la sortie d'impulsions d'un des modules élémentaires du diviseur de fréquence, le décodeur étant muni d'une sortie supplémentaire reliée à l'entrée de commande du multiplexeur permettant à celui-ci de délivrer à sa sortie un signal fenêtre constitué par le signal délivré par la sortie d'impulsions du j^{ème} module élémentaire, j variant de 1 à N en fonction du signal de commande.

Une telle variante permet la sélection, par voie de multiplexage, de celui des signaux délivrés par les sorties d'impulsions des modules élémentaires qui doit constituer le signal fenêtre, et donc le choix de la largeur d'impulsion du dit signal, qui définit la précision de la détection du verrouillage.

L'invention concerne également, sous sa forme la plus générale, un détecteur de synchronisme, muni d'une première entrée destinée à recevoir un premier signal d'entrée, d'une deuxième entrée destinée à recevoir un deuxième signal d'entrée, et d'une sortie, détecteur comportant des moyens pour générer un signal, dit signal fenêtre, actif pendant certains intervalles de temps, englobant chacun un front actif du premier signal d'entrée, et une bascule mémoire munie d'une entrée de données, d'une entrée d'horloge et d'une sortie de données, l'entrée de données étant destinée à recevoir le signal fenêtre, l'entrée d'horloge étant destinée à recevoir le deuxième signal d'entrée, et la sortie de données formant la deuxième sortie du détecteur de synchronisme.

Un tel détecteur peut être avantageusement mis en oeuvre dans tous types de systèmes dont les comportements doivent évoluer en fonction de la fréquence de signaux qu'ils reçoivent en entrée, comme par exemple des modulateurs/démodulateurs ou des filtres adaptatifs.

Une variante d'un tel détecteur, destinée à l'immuniser contre des situations dans lesquelles un front actif du deuxième signal surviendrait de manière fortuite pendant un intervalle de temps où le signal fenêtre serait actif, sans que les premier et deuxième signaux d'entrée ne soient pour autant en phase, présente un détecteur de synchronisme tel que décrit ci-dessus, caractérisé en ce qu'il comporte un filtre numérique passe-bas inséré entre la sortie de données de la bascule mémoire et la sortie du détecteur de synchronisme.

L'invention sera mieux comprise à l'aide de la description suivante de quelques modes de réalisation, faite à titre d'exemple non limitatif et en regard des dessins annexés, dans lesquels :
- la figure 1 est un schéma fonctionnel partiel décrivant un dispositif de sélection de fréquence selon l'invention,
- la figure 2 est un schéma fonctionnel partiel décrivant un filtre numérique passe-bas présent dans un dispositif de sélection de fréquence selon une variante de l'invention,
- la figure 3 est un schéma fonctionnel partiel décrivant un diviseur de fréquence présent dans un dispositif de sélection de fréquence selon une variante de l'invention,
- la figure 4 est un schéma fonctionnel partiel décrivant un diviseur de fréquence présent dans un dispositif de sélection de fréquence selon une autre variante de l'invention,
- la figure 5 est un ensemble de chronogrammes décrivant l'évolution de signaux présents dans un dispositif de sélection de fréquence selon cette autre variante de l'invention, et
- la figure 6 est un ensemble de chronogrammes décrivant l'évolution de signaux présents dans un dispositif de sélection de fréquence comprenant un filtre passe-bas.

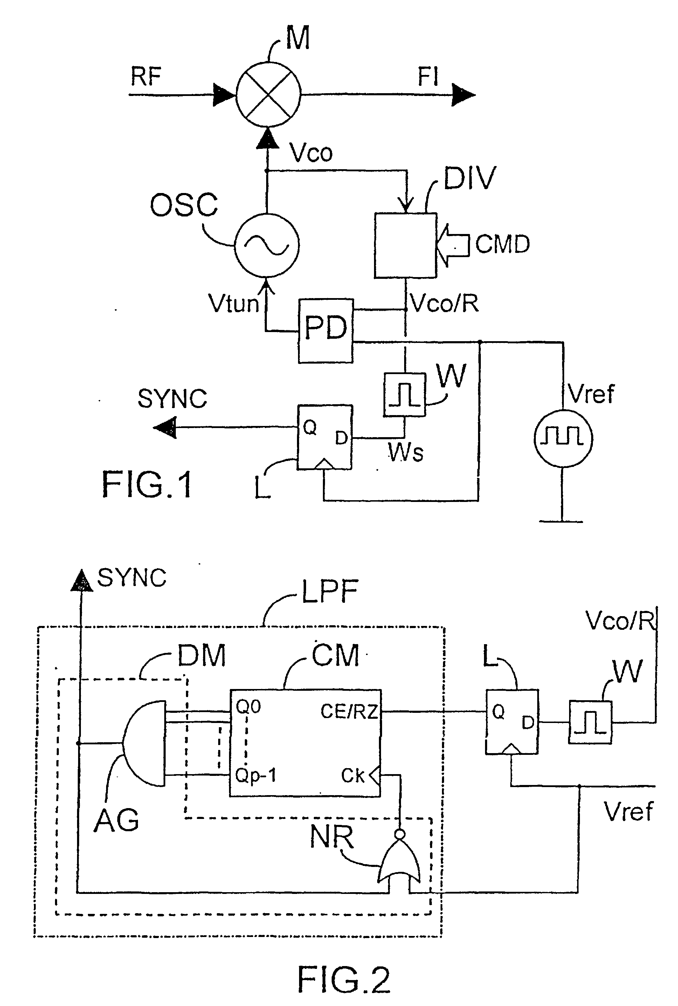

La figure 1 représente schématiquement un dispositif de sélection de fréquence selon l'invention. Ce dispositif présente une première entrée recevant un signal radio-électrique RF dont la fréquence est appelée fréquence radio. Ce signal radio-électrique est sélectionné au sein d'un ensemble de signaux dont les fréquences sont situées dans une gamme donnée. Le dispositif présente en outre une deuxième entrée recevant un signal CMD dit de commande définissant la fréquence du signal radio-électrique à sélectionner. Le dispositif présente de plus une première sortie délivrant un signal FI dont la fréquence, dite fréquence intermédiaire, est fixée. Le dispositif présente enfin une deuxième sortie délivrant un signal SYNC indiquant que la fréquence radio correspond à la fréquence définie par le signal de commande. Le dispositif comporte :
. un oscillateur OSC présentant une entrée de réglage recevant un signal dit de réglage Vtun, et une sortie délivrant un signal Vco dont la fréquence dépend de la valeur du signal de réglage Vtun,
. un mélangeur M présentant une première entrée, formant la première entrée du dispositif, recevant le signal radio-électrique RF, une deuxième entrée reliée à la sortie de l'oscillateur OSC, et une sortie, formant la première sortie du dispositif, délivrant le signal FI dont la fréquence est égale à la différence entre la fréquence radio du signal RF reçu sur la première entrée et celle du signal Vco reçu sur la deuxième entrée,
. un diviseur de fréquence DIV présentant une première entrée reliée à la sortie de l'oscillateur OSC, une deuxième entrée formant la deuxième entrée du dispositif, et une sortie délivrant un signal Vco/R dont la fréquence est égale à la fréquence du signal reçu sur la première entrée, divisée par un nombre défini par le signal de commande CMD reçu sur la deuxième entrée,
. un détecteur de phase PD, présentant une première entrée recevant un signal Vref dit de référence dont la fréquence est fixe, une deuxième entrée reliée à la sortie du diviseur de fréquence DIV, et une sortie reliée à l'entrée de l'oscillateur OSC.

Dans un tel dispositif, le choix du rapport entre la fréquence du signal de sortie Vco de l'oscillateur OSC et celle du signal de sortie Vco/R du diviseur de fréquence, rapport que l'on notera R, permet la sélection du signal radio-électrique RF. En effet, la fréquence intermédiaire du signal FI généré par le mélangeur M est égale à la différence entre la fréquence radio et la fréquence du signal de sortie Vco de l'oscillateur OSC. La fréquence intermédiaire étant fixée, la fréquence radio du signal radio-électrique dépend uniquement de la fréquence du signal Vco. Or, en situation de verrouillage, la fréquence du signal Vco est égale à R fois Vref.

Le dispositif représenté à la figure 1 comporte en outre des moyens W pour générer un signal Ws, dit signal fenêtre, actif pendant certains intervalles de temps, englobant chacun un front actif du signal de sortie du diviseur de fréquence Vco/R. Le dispositif comporte une bascule mémoire L munie d'une entrée de données D, d'une entrée d'horloge et d'une sortie de données Q, l'entrée de données D recevant le signal fenêtre Ws, l'entrée d'horloge recevant le signal de référence Vref, et la sortie de données Q formant la deuxième sortie du dispositif. Le signal SYNC délivré par la sortie de données Q de la bascule mémoire L indique le verrouillage lorsqu'il est au niveau actif.

Un front actif du signal de sortie Vco/R du diviseur de fréquence DIV peut coïncider de manière fortuite avec un front actif du signal de référence Vref, sans que le dispositif ne soit pour autant en situation de verrouillage. Dans une telle situation, le dispositif représenté sur la figure 1 placera le signal de sortie SYNC de la bascule mémoire L au niveau actif et signalera, de manière erronée, un verrouillage. Il est souhaitable de doter le dispositif de moyens de filtrage afin de l'immuniser contre de telles situations.

La figure 2 représente un filtre numérique passe-bas LPF, inséré entre la sortie de données Q de la bascule mémoire L et la deuxième sortie du dispositif. Dans cet exemple, le filtre numérique comporte :
. un compteur CM modulo M présentant une entrée d'autorisation de comptage/initialisation CE/RZ reliée à la sortie Q de la bascule mémoire L, une entrée d'horloge Ck recevant le signal de référence Vref, et P sorties, avec M=2^{P}, un niveau actif sur l'entrée d'autorisation de comptage/initialisation CE/RZ autorisant le compteur CM à compter, un niveau inactif plaçant au niveau inactif chacune des sorties du compteur CM,
. un module DM dit de détection, présentant P entrées reliées aux P sorties du compteur, et une sortie, formant la deuxième sortie du dispositif, délivrant un signal SYNC qui est placé au niveau actif lorsque toutes les sorties du compteur sont au niveau actif, et maintenu à ce niveau jusqu'à ce que le compteur reçoive un niveau inactif sur son entrée d'autorisation de comptage/initialisation.

Le module de détection DM comporte une porte "ET" logique AG présentant P entrées reliées aux P sorties du compteur, et une sortie délivrant le signal SYNC, dont le niveau est actif lorsque toutes les sorties du compteur CM sont au niveau actif. Le module de détection DM comporte une porte "NON-OU" logique NR présentant une entrée reliée à la sortie de la porte "ET" logique AG, une entrée recevant le signal de référence Vref, et une sortie reliée à l'entrée d'horloge Ck du compteur CM, qui reçoit donc, lorsque le signal SYNC est au niveau inactif, l'inverse du signal de référence Vref. Lorsque le compteur CM atteint le dernier état de son cycle de comptage, dans lequel toutes ses sorties sont au niveau actif, le signal SYNC est au niveau actif et interrompt, au moyen de la porte "NON-OU" logique NR, l'arrivée des impulsions d'horloge sur l'entrée d'horloge Ck du compteur CM. Le comptage est alors suspendu et le compteur CM est maintenu dans le dernier état de son cycle de comptage. En cas de perte de synchronisme entre les signaux Vco/R et Vref, la sortie Q de la bascule mémoire L est placée au niveau inactif, et place toutes les sorties du compteur CM au niveau inactif. Le signal SYNC est alors placé au niveau inactif, ce qui permet à l'entrée d'horloge du compteur CM de recevoir à nouveau l'inverse du signal de référence Vref. Le compteur ne pourra toutefois compter que si le dispositif se trouve en situation de verrouillage, c'est-à-dire lorsque la sortie Q de la bascule mémoire L retrouvera un niveau actif.

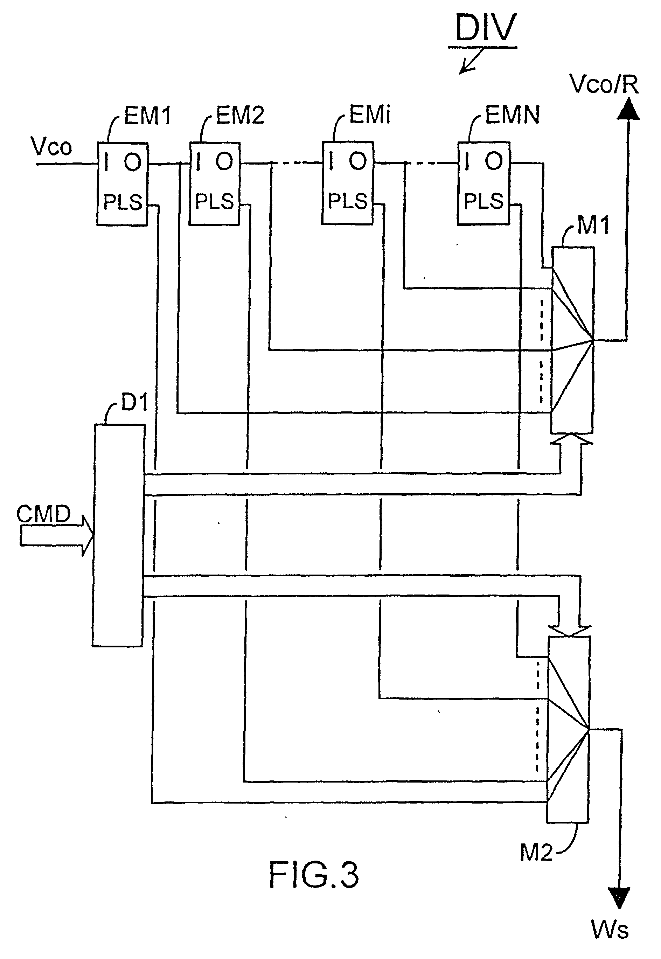

La figure 3 montre un mode d'obtention du signal fenêtre. Cette figure représente schématiquement un diviseur de fréquence DIV présent dans un dispositif de sélection de fréquence selon une variante de l'invention. Ce diviseur de fréquence DIV est composé de N modules EM1, EM2,...EMN, dits modules élémentaires, disposés en cascade, munis chacun d'une entrée de données I, d'une sortie de données O et d'une sortie d'impulsions PLS. L'entrée du premier module élémentaire EM1 forme la première entrée du diviseur de fréquence DIV. Chaque module élémentaire effectue une division de fréquence et délivre à sa sortie de données O un signal résultant de cette division et à sa sortie d'impulsions PLS un signal qui, durant chaque période du signal de sortie Vco/R du diviseur de fréquence DIV, est actif pendant le premier état actif du signal d'entrée et inactif sinon. Si, par exemple, ces modules élémentaires sont des bascules mémoires, chaque module effectuera une division par deux. La sortie du i^{ème} module élémentaire, i pouvant varier de 1 à N, est sélectionnée au moyen du signal de commande CMD reçu sur la deuxième entrée du diviseur de fréquence DIV pour former la sortie du dit diviseur. Cette sélection est réalisée ici au moyen d'un premier multiplexeur M1, qui présente N entrées de données reliées chacune à la sortie d'un module élémentaire, une entrée de commande et une sortie de données formant la sortie du diviseur de fréquence DIV et délivrant le signal Vco/R. Le diviseur de fréquence DIV comporte un décodeur D1 présentant une entrée et une première et une deuxième sorties, l'entrée du décodeur D1 recevant le signal de commande CMD, le décodeur D1 délivrant sur sa première sortie un signal de commande permettant au premier multiplexeur M1 de sélectionner celle des sorties des modules élémentaires qui constituera la sortie du diviseur de fréquence DIV. Ce système de multiplexage des sorties permet le réglage du rapport R entre la fréquence du signal d'entrée Vco du diviseur de fréquence et celle de son signal de sortie Vco/R. Si les modules élémentaires sont des bascules mémoires, et si la sortie du i^{ème} module élémentaire EMi est sélectionnée pour constituer la sortie du diviseur de fréquence DIV, la fréquence du signal de sortie Vco/R sera 2i fois inférieure à celle du signal d'entrée Vco (R=2i). Le diviseur de fréquence DIV représenté à la figure 3 comporte en outre un deuxième multiplexeur M2, qui présente N entrées de données reliées chacune à la sortie d'impulsions PLS d'un module élémentaire, une entrée de commande et une sortie de données délivrant le signal fenêtre Ws. Le décodeur D1 délivre sur sa deuxième sortie un signal de commande permettant au deuxième multiplexeur M2 de sélectionner celui des signaux délivrés par les sorties d'impulsions des i premiers modules élémentaires qui constituera le signal fenêtre Ws. Le décodeur D1 peut donc ainsi adapter la largeur d'impulsion du signal fenêtre Ws à celle du signal de sortie Vco/R du diviseur DIV.

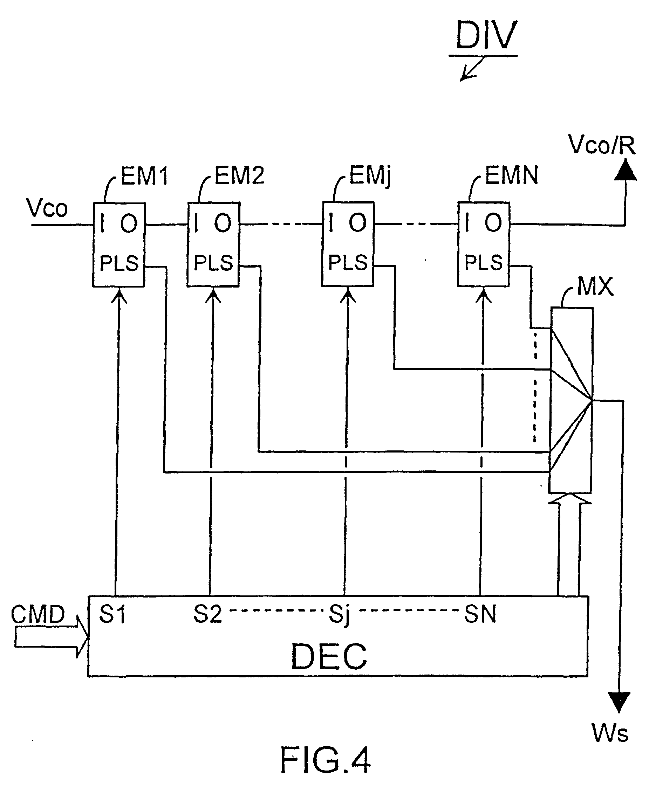

La figure 4 représente schématiquement un diviseur de fréquence DIV présent dans un dispositif de sélection de fréquence selon une autre variante de l'invention. Ce diviseur de fréquence DIV comporte :
. N modules dits élémentaires EM1, EM2,...EMN, chacun d'entre eux présentant une entrée de données I recevant un signal d'entrée et une sortie de données O délivrant un signal dont la fréquence est K fois inférieure à celle du signal reçu sur son entrée, la sortie O d'un module élémentaire étant reliée à l'entrée I du module élémentaire suivant, l'entrée I du premier module élémentaire EM1 formant la première entrée du diviseur de fréquence DIV, la sortie O du N^{ème} module élémentaire EMN formant la sortie du diviseur de fréquence DIV, chaque module présentant en outre une sortie d'impulsions PLS délivrant un signal qui, durant chaque période du signal de sortie Vco/R du diviseur de fréquence DIV, est actif pendant le premier état actif du signal d'entrée et inactif sinon,
. un décodeur DEC présentant une entrée formant la deuxième entrée du diviseur de fréquence, et N sorties, S1, S2,...SN, chacune définissant le rapport K entre la fréquence du signal d'entrée d'un module élémentaire et celle de son signal de sortie. Dans un tel diviseur de fréquence, et contrairement à celui qui a été décrit précédemment, ce n'est pas le choix de la sortie d'un des modules élémentaires qui définit le rapport R entre la fréquence du signal d'entrée du diviseur et celle de son signal de sortie. Le réglage de ce rapport R est réalisé ici en agissant directement sur le rapport K de chaque module élémentaire, et R est égal à la somme de ces rapports (R=K1+K2+...+KN). Le diviseur DIV comporte en outre un multiplexeur MX présentant N entrées de données, une entrée de commande et une sortie de données, les N entrées de données étant chacune reliée à la sortie d'impulsions PLS d'un des modules élémentaires EM1, EM2,...EMN, du diviseur de fréquence DIV, le décodeur DEC étant muni d'une sortie supplémentaire reliée à l'entrée de commande du multiplexeur MX, permettant à celui-ci de délivrer à sa sortie un signal fenêtre Ws constitué par le signal délivré par la sortie d'impulsions du j^{ème} module élémentaire, j variant de 1 à N en fonction du signal de commande. Un tel système permet d'adapter la largeur d'impulsion du signal fenêtre Ws à celle du signal de sortie du diviseur Vco/R.

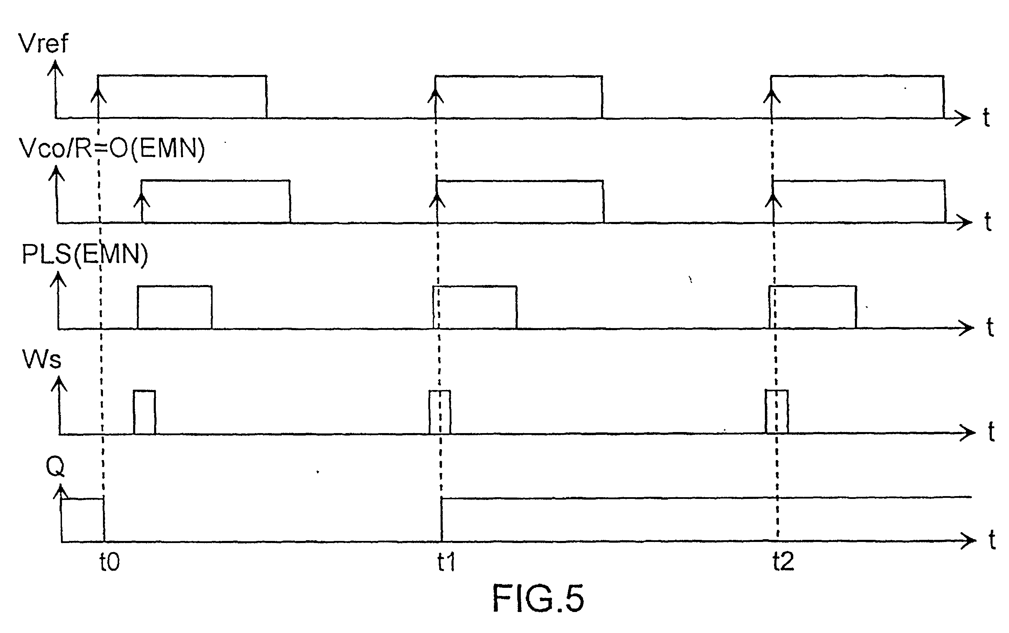

La figure 5 montre l'évolution de signaux présents dans un dispositif comportant un tel diviseur de fréquence. La fréquence du signal Vref est fixée et correspond à une période T. La sortie O(EMN) du Nème module élémentaire EMN du diviseur de fréquence DIV délivre le signal Vco/R de sortie de celui-ci. Le signal de sortie, noté O(EMN), du module élémentaire EMN est en retard par rapport au signal qu'il reçoit en entrée, qui est le signal de sortie du module élémentaire précédent, EMN-1, et aussi par rapport au signal, noté PLS(EMN) qui est délivré par la sortie d'impulsions de EMN. Ce retard est intrinsèque au module élémentaire et correspond à un temps de transit du signal électrique entre l'entrée et la sortie du module élémentaire. Dans l'exemple décrit ici, le dernier module EMN effectue une division de la fréquence par deux (KN=2). Le signal Ws est le signal délivré par la sortie d'impulsions de l'un des modules qui précèdent le module élémentaire EMN. Par rapport au signal Ws, le retard de Vco/R est encore plus grand, étant égal à la somme des retards occasionnés par les modules élémentaires qui séparent la sortie du diviseur de fréquence du module élémentaire dont la sortie d'impulsions délivre le signal fenêtre Ws. La largeur d'impulsion du signal fenêtre Ws est évidemment plus faible que celle de PLS(EMN). Le signal fenêtre Ws encadre donc le front actif du signal de sortie Vco/R du diviseur de fréquence.

Le cas de figure représenté ici est celui où Vref et Vco/R ont eu des fronts actifs synchrones à l'instant T-t0, qui n'est pas représenté sur la figure, ce qui a eu pour effet de placer la sortie de données Q de la bascule mémoire L au niveau actif. A l'instant t0, qui correspond à un front actif de Vref, Vco/R et Vref ne sont plus synchrones. Le signal fenêtre Ws, qui est présent à l'entrée de données D de la bascule mémoire L, est alors au niveau inactif lors du front actif de Vref, et la sortie Q de la bascule mémoire L est placée au niveau inactif. A l'instant t1, Vco/R et Vref sont synchrones. Le signal fenêtre Ws est alors au niveau actif lors du front actif de Vref, et la sortie Q de la bascule mémoire L est placée au niveau actif. A l'instant t2, Vco/R et Vref sont toujours synchrones. La sortie Q de la bascule mémoire L reste donc au niveau actif.

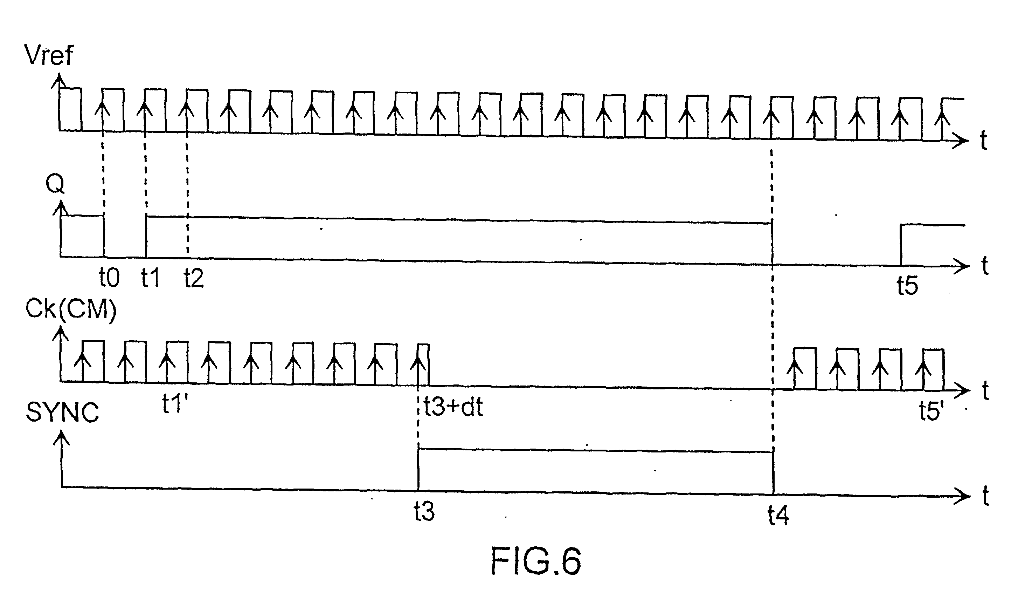

La figure 6 montre l'évolution de signaux présents dans un dispositif de sélection de fréquence comprenant un filtre passe-bas tel que représenté dans la figure 2. L'échelle des temps a été agrandie par rapport à celle de la figure 5, afin de permettre d'observer les effets du filtrage. Dans ce cas particulier, le compteur CM est un compteur modulo 8. Ainsi que décrit plus haut, les signaux Vco/R et Vref ne sont pas synchrones à l'instant t0. La sortie de données Q de la bascule mémoire L est donc placée au niveau inactif qui est transmis à l'entrée d'autorisation de comptage/initialisation CE/RZ du compteur CM. Les sorties de celui-ci sont alors toutes au niveau inactif. A partir de t1, les signaux Vco/R et Vref sont synchrones. Le compteur CM commence donc son cycle de comptage à l'instant t1' décalé par rapport à t1 d'une demi-période du signal Vref du fait de l'inversion de celui-ci par la porte "NON-OU" logique NR, cycle qui se termine en t3 lorsque survient le septième front actif sur l'entrée d'horloge Ck(CM) du compteur CM. Le signal de sortie SYNC de la porte "ET" logique AG est alors placé au niveau actif et place la sortie de la porte "NON-OU" logique NR au niveau inactif, suspendant ainsi à partir de t3 + dt l'arrivée des impulsions d'horloge sur l'entrée d'horloge Ck(CM) du compteur CM, lequel est donc maintenu dans le dernier état de son cycle de comptage. Le délai dt est dû au temps de transit au travers des portes logiques AG et NR. Le signal SYNC est donc maintenu au niveau actif. A l'instant t4, les signaux Vco/R et Vref ne sont plus synchrones. La sortie de données Q de la bascule mémoire L est donc placée au niveau inactif, remettant ainsi toutes les sorties du compteur CM, et donc le signal SYNC, au niveau inactif. L'entrée d'horloge Ck(CM) du compteur CM reçoit alors à nouveau les impulsions d'horloge, mais le compteur ne reprend pas son cycle de comptage, étant en situation d'initialisation tant que la sortie Q de la bascule mémoire L reste au niveau inactif. A l'instant t5, les signaux Vco/R et Vref sont à nouveau synchrones. La sortie de données Q de la bascule mémoire L est donc placée au niveau actif, autorisant ainsi le compteur CM a commencer son cycle de comptage à l'instant t5' décalé par rapport à t5 d'une demi-période du signal Vref. Le fait qu'avant t0, l'entrée d'horloge Ck(CM) du compteur CM recevait des impulsions d'horloge prouve que le synchronisme entre les deux signaux Vco/R et Vref avait été trop bref pour que le compteur puisse effectuer un cycle de comptage complet, à l'issue duquel son entrée d'horloge aurait dû être inhibée. L'association du compteur CM et du module de détection DM équivaut donc à un filtre passe-bas, ne prenant en compte dans cet exemple que les états actifs d'une durée supérieure ou égale à sept périodes du signal de référence Vref.

Les figures 5 et 6 contiennent des signaux pour lesquels le niveau actif est le niveau logique "1" et le niveau inactif le niveau logique "0". De même, les fronts actifs sont des fronts montants. La description qui a été faite précédemment est aisément transposable au cas où le niveau actif serait le niveau logique "0", le niveau inactif le niveau logique "1" et où les fronts actifs seraient des fronts descendants.

## Revendications

1. Dispositif de sélection de fréquence présentant une première entrée destinée à recevoir un signal radio-électrique dont la fréquence est appelée fréquence radio (RF), ce signal radio-électrique étant sélectionné au sein d'un ensemble de signaux dont les fréquences sont situées dans une gamme donnée, dispositif présentant une deuxième entrée destinée à recevoir un signal dit de commande définissant la fréquence du signal radio-électrique à sélectionner (CMD), dispositif présentant une première sortie destinée à délivrer signal dont la fréquence, dite fréquence intermédiaire, est fixée (FI), dispositif présentant une deuxième sortie destinée à délivrer un signal indiquant que la fréquence radio correspond à la fréquence définie par le signal de commande (SYNC), dispositif comportant :
. un oscillateur (OSC) présentant une entrée de réglage destinée à recevoir un signal dit de réglage, et une sortie destinée à délivrer un signal dont la fréquence dépend de la valeur du signal de réglage,
. un mélangeur (M) présentant une première entrée, formant la première entrée du dispositif, destinée à recevoir le signal radio-électrique, une deuxième entrée reliée à la sortie de l'oscillateur, et une sortie, formant la première sortie du dispositif, destinée à délivrer un signal dont la fréquence est égale à la différence entre la fréquence du signal reçu sur la première entrée et celle du signal reçu sur la deuxième entrée,
. un diviseur (DIV) de fréquence présentant une première entrée reliée à la sortie de l'oscillateur, une deuxième entrée formant la deuxième entrée du dispositif, et une sortie destinée à délivrer un signal dont la fréquence est égale à la fréquence du signal reçu sur la première entrée, divisée par un nombre défini par le signal de commande reçu sur la deuxième entrée,
. un détecteur de phase (PD), présentant une première entrée destinée à recevoir un signal dit de référence dont la fréquence est fixe, une deuxième entrée reliée à la sortie du diviseur de fréquence, et une sortie reliée à l'entrée de l'oscillateur,
dispositif **caractérisé en ce qu'**il comporte en outre des moyens pour générer un signal (W), dit signal fenêtre, actif pendant certains intervalles de temps, englobant chacun un front actif du signal de sortie du diviseur de fréquence, et une bascule mémoire (L) munie d'une entrée de données, d'une entrée d'horloge et d'une sortie de données, l'entrée de données étant destinée à recevoir le signal fenêtre, l'entrée d'horloge étant destinée à recevoir le signal de référence, et la sortie de données formant la deuxième sortie du dispositif.

2. Dispositif de sélection de fréquence selon la revendication 1, **caractérisé en ce qu'**il comporte un filtre numérique passe-bas (LPF) inséré entre la sortie de données de la bascule mémoire et la deuxième sortie du dispositif.

3. Dispositif de sélection de fréquence selon la revendication 2, **caractérisé en ce que** le filtre numérique comporte
. un compteur modulo M (CM) présentant une entrée d'autorisation de comptage/initialisation reliée à la sortie de la bascule mémoire, une entrée d'horloge destinée à recevoir le signal de référence, et P sorties, avec M=2^{P}, un niveau actif sur l'entrée d'autorisation de comptage/initialisation autorisant le compteur à compter, un niveau inactif plaçant au niveau inactif chacune des sorties du compteur,
. un module dit de détection (DM), présentant P entrées reliées aux P sorties du compteur, et une sortie, formant la deuxième sortie du dispositif, destinée à délivrer un signal qui est placé au niveau actif lorsque toutes les sorties du compteur sont au niveau actif, et maintenu à ce niveau jusqu'à ce que le compteur reçoive un niveau inactif sur son entrée d'autorisation de comptage/initialisation.

4. Dispositif de sélection de fréquence selon l'une des revendications 1, 2 ou 3, dans lequel le diviseur de fréquence est composé de N modules, dits modules élémentaires (EM1..EMN), disposés en cascade, munis chacun d'une entrée de données, d'une sortie de données et d'une sortie d'impulsions, l'entrée du premier module élémentaire formant la première entrée du diviseur de fréquence, chaque module élémentaire étant destiné à effectuer une division de fréquence et à délivrer à sa sortie de données un signal résultant de cette division et à sa sortie d'impulsions un signal qui, durant chaque période du signal de sortie du diviseur de fréquence, est actif pendant le premier état actif du signal d'entrée et inactif sinon, dispositif **caractérisé en ce que**, si la sortie du i^{ème} module élémentaire, i pouvant varier de 1 à N, est sélectionnée au moyen du signal de commande reçu sur la deuxième entrée du diviseur de fréquence pour former la sortie du dit diviseur, le signal fenêtre est l'un des signaux délivrés à la sortie d'impulsions d'un des i premiers modules élémentaires.

5. Dispositif de sélection de fréquence selon l'une des revendications 1, 2 ou 3, dans lequel le diviseur de fréquence comporte :
. N modules dits élémentaires (EM1..EMN), chacun d'entre eux présentant une entrée de données destinée à recevoir un signal d'entrée et une sortie de données destinée à délivrer un signal dont la fréquence est K fois inférieure à celle du signal reçu sur son entrée, la sortie d'un module élémentaire étant reliée à l'entrée du module élémentaire suivant, l'entrée du premier module élémentaire formant la première entrée du diviseur de fréquence, la sortie du N^{ème} module élémentaire formant la sortie du diviseur de fréquence, chaque module présentant en outre une sortie d'impulsions destinée à délivrer un signal qui, durant chaque période du signal de sortie du diviseur de fréquence, est actif pendant le premier état actif du signal d'entrée et inactif sinon,
. un décodeur (D1) présentant une entrée formant la deuxième entrée du diviseur de fréquence, et N sorties, chacune définissant le rapport K entre la fréquence du signal d'entrée d'un module élémentaire et celle de son signal de sortie,
dispositif **caractérisé en ce que** le signal fenêtre est l'un des signaux délivrés par les sorties d'impulsions (PLS) des modules élémentaires.

6. Dispositif de sélection de fréquence selon la revendication 5, **caractérisé en ce qu'**il comporte un multiplexeur (M1) présentant N entrées de données, une entrée de commande et une sortie de données, chacune des N entrées de données étant reliée à la sortie d'impulsions d'un des modules élémentaires du diviseur de fréquence, le décodeur étant muni d'une sortie supplémentaire reliée à l'entrée de commande du multiplexeur permettant à celui-ci de délivrer à sa sortie un signal fenêtre constitué par le signal délivré par la sortie d'impulsions du j^{ème} module élémentaire, j variant de 1 à N en fonction du signal de commande.

7. Détecteur de synchronisme, muni d'une première entrée (Vco/R) destinée à recevoir un premier signal d'entrée, d'une deuxième entrée (Vref) destinée à recevoir un deuxième signal d'entrée, et d'une sortie (SYNC), détecteur comportant des moyens pour générer un signal, dit signal fenêtre, actif pendant certains intervalles de temps, englobant chacun un front actif du premier signal d'entrée, et une bascule mémoire (L) munie d'une entrée de données, d'une entrée d'horloge et d'une sortie de données, l'entrée de données étant destinée à recevoir le signal fenêtre, l'entrée d'horloge étant destinée à recevoir le deuxième signal d'entrée, et la sortie de données formant la sortie du détecteur de synchronisme.

8. Détecteur de synchronisme selon la revendication 7. **caractérisé en ce qu'**il comporte un filtre numérique passe-bas (LPF) inséré entre la sortie de données de la bascule mémoire et la sortie du détecteur de synchronisme.

## Patentansprüche

1. Einrichtung zur Frequenzselektion, die einen ersten Eingang aufweist, zum Erhalt eines Funksignals bestimmt, dessen Frequenz Funkfrequenz (RF) bezeichnet wird, wobei dieses Funksignal im Rahmen eines Signalsatzes selektiert wird, dessen Frequenzen in einem bestimmten Bereich liegen, die Einrichtung einen zweiten Eingang aufweist, zum Erhalt eines sogenannten Steuersignals bestimmt, das die Frequenz des zu selektierenden Funksignals definiert (CMD), die Einrichtung einen ersten Ausgang aufweist, zur Abgabe eines Signals bestimmt, dessen Frequenz Zwischenfrequenz bezeichnet wird, und die feststeht (FI), die Einrichtung einen zweiten Ausgang aufweist, zur Abgabe eines Signals, zur Anzeige dafür bestimmt, daß die Funkfrequenz der vom Steuersignal definierten Frequenz entspricht (SYNC), und die Einrichtung aufweist:
. einen Oszillator (OSC) mit einem Regeleingang zum Erhalt eines sogenannten Regelsignals und einem Ausgang zur Abgabe eines Signals, dessen Frequenz vom Wert des Regelsignals abhängt,
. einen Mischer (M) mit einem ersten Eingang, der den ersten Eingang der Einrichtung bildet, zum Erhalt des Funksignals, einem zweiten Eingang, mit dem Ausgang des Oszillators verbunden, und einem Ausgang, der den ersten Ausgang der Einrichtung bildet, zur Abgabe eines Signals bestimmt, dessen Frequenz gleich der Differenz zwischen der Frequenz des am ersten Eingang erhaltenen Signals und der des am zweiten Eingang erhaltenen Signals ist,
. einen Frequenzteiler (DIV) mit einem ersten Eingang, mit dem Ausgang des Oszillators verbunden, und einem zweiten Eingang, der den zweiten Eingang der Einrichtung bildet, und einem Ausgang zur Abgabe eines Signals, dessen Frequenz gleich der Frequenz des am ersten Eingang erhaltenen Signals ist, geteilt durch eine vom Steuersignal definierte Zahl, am zweiten Eingang erhalten,
. einen Phasendetektor (PD) mit einem ersten Eingang, zum Erhalt eines sogenannten Referenzsignals bestimmt, dessen Frequenz fest ist, und einem zweiten Eingang, mit dem Ausgang des Frequenzteilers verbunden, und einem Ausgang, mit dem Eingang des Oszillators verbunden,
Einrichtung **dadurch gekennzeichnet, daß** sie Verfahren zum Erzeugen eines Signals (W) enthält, dem sogenannten Fenstersignal, aktiv über bestimmte Zeitintervalle, die jeweils eine aktive Flanke des Ausgangssignals des Frequenzteilers einschließen, und einen Flip-Flop-Speicher (L), versehen mit einem Dateneingang, einem Uhreingang und einem Datenausgang, wobei der Dateneingang dazu dient, das Fenstersignal zu erhalten, der Uhreingang dazu dient, das Referenzsignals zu erhalten und der Datenausgang den zweiten Ausgang der Einrichtung bildet.

2. Einrichtung zur Frequenzselektion nach Anspruch 1, **dadurch gekennzeichnet, daß** sie einen digitalen Tiefpaßfilter (LPF) aufweist, zwischen den Datenausgang des Flip-Flop-Speichers und den zweiten Ausgang der Einrichtung eingefügt.

3. Einrichtung zur Frequenzselektion nach Anspruch 2, **dadurch gekennzeichnet, daß** der digitale Filter aufweist:
. einen Modulo-Zähler (CM) mit einem Eingang zur Autorisation des Zählens/Initialisierens, verbunden mit dem Ausgang des Flip-Flop-Speichers, einem Uhreingang für den Erhalt des Referenzsignals und P Ausgängen, mit M=2^{P}, einem aktiven Stand am Eingang zur Autorisation des Zählens/Initialisierens, um dem Zähler das Zählen zu autorisieren, einem inaktiven Stand, um jeden der Ausgänge des Zählers auf inaktiven Stand zu bringen,
. ein sogenanntes Detektionsmodul (DM), das P Eingänge aufweist, mit den P Ausgängen des Zählers verbunden, und einen Ausgang, der den zweiten Ausgang der Einrichtung bildet, zum Abgeben eines Signals bestimmt, das auf aktiven Stand gebracht wird, wenn alle Ausgänge des Zählers auf aktivem Stand sind, und auf diesem Stand beibehalten wird, bis der Zähler einen inaktiven Stand an seinem Eingang zur Autorisation des Zählens/Initialisierens erhält.

4. Einrichtung zur Frequenzselektion nach einem der Ansprüche 1, 2 oder 3, in der der Frequenzteiler aus N Modulen besteht, sogenannten elementaren Modulen (EM1...EMN), in Kaskade angeordnet, jeweils mit einem Dateneingang, einem Datenausgang und einem Impulsausgang versehen, wobei der Eingang des ersten elementaren Moduls den ersten Eingang des Frequenzteilers bildet, jedes elementare Modul zur Durchführung einer Frequenzteilung und zur Abgabe an seinem Datenausgang eines Signals bestimmt ist, das aus dieser Teilung hervorgeht, und an seinem Impulsausgang eines Signals, das über jede Periode des Ausgangssignals des Frequenzteilers über den ersten aktiven Zustand des Eingangssignals aktiv, und ansonsten inaktiv ist, Einrichtung **dadurch gekennzeichnet, daß** wenn der Ausgang des i-ten elementaren Moduls, wobei i von 1 bis N variieren kann, über das Steuersignal selektiert wird, am zweiten Eingang des Frequenzteilers erhalten, um den Ausgang des besagten Teilers zu bilden, das Fenstersignal eines der am Impulsausgang eines der i ersten elementaren Module abgegebenen Signale ist.

5. Einrichtung zur Frequenzselektion nach einem der Ansprüche 1, 2 oder 3, in der der Frequenzteiler aufweist:
. N sogenannte elementare Module (EM1...EMN), die jeweils einen Dateneingang zum Erhalt eines Eingangssignals und einen Datenausgang zur Abgabe eines Signals aufweisen, dessen Frequenz K-mal unter der des an seinem Eingang erhaltenen Signals liegt, wobei der Ausgang eines elementaren Moduls mit dem Eingang des folgenden elementaren Moduls verbunden ist, der Eingang des ersten elementaren Moduls den ersten Eingang des Frequenzteilers bildet, der Ausgang des N-ten elementaren Moduls den Ausgang des Frequenzteilers bildet, jedes Modul zudem einen Impulsausgang aufweist, um ein Signal abzugeben, das über jede Periode des Ausgangssignals des Frequenzteilers über den ersten aktiven Zustand des Eingangssignals aktiv, und ansonsten inaktiv ist,
. einen Dekodierer (D1) mit einem Eingang, der den zweiten Eingang des Frequenzteilers bildet, und N Ausgängen, die jeweils das Verhältnis K zwischen der Frequenz des Eingangssignals eines elementaren Moduls und der seines Ausgangssignals definieren,
Einrichtung **dadurch gekennzeichnet, daß** das Fenstersignal eines der von den Impulsausgängen (PLS) der elementaren Module abgegebenen Signale ist.

6. Einrichtung zur Frequenzselektion nach Anspruch 5, **dadurch gekennzeichnet, daß** sie einen Multiplexer (M1) mit N Dateneingängen, einen Steuereingang und einen Datenausgang aufweist, wobei jeder der N Dateneingänge mit dem Impulsausgang eines der elementaren Module des Frequenzteilers verbunden und der Dekodierer mit einem zusätzlichen Ausgang versehen ist, mit dem Steuereingang des Multiplexers verbunden, um es diesem zu ermöglichen, an seinem Ausgang ein Fenstersignal abzugeben, gebildet aus dem am Impulsausgang des j-ten elementaren Moduls abgegebenen Signal, wobei j entsprechend dem Steuersignal von 1 bis N variiert.

7. Synchronismusdetektor, versehen mit einem ersten Eingang (Vco/R), bestimmt für den Erhalt eines ersten Eingangssignals, einem zweiten Eingang (Vref), bestimmt für den Erhalt eines zweiten Eingangssignals, und einem Ausgang (SYNC), wobei der Detektor Verfahren enthält, um ein Signal zu erzeugen, das sogenannte Fenstersignal, aktiv über bestimmte Zeitintervalle, die jeweils eine aktive Flanke des ersten Eingangssignals einschließen, und einen Flip-Flop-Speicher (L), versehen mit einem Dateneingang, einem Uhreingang und einem Datenausgang, wobei der Dateneingang dazu dient, das Fenstersignal zu erhalten, der Uhreingang dazu dient, den zweiten Signaleingang zu erhalten der Datenausgang den Ausgang des Synchronismusdetektors bildet.

8. Synchronismusdetektor nach Anspruch 7, **dadurch gekennzeichnet, daß** er einen digitalen Tiefpaßfilter (LPF) aufweist, zwischen den Datenausgang des Flip-Flop-Speichers und den Ausgang des Synchronismusdetektors eingefügt.

## Claims

1. A frequency-selection device having a first input intended to receive a radio-electric signal whose frequency is referred to as radio frequency (RF), this radio-electric signal being selected from a number of signals having frequencies which are situated in a given range, said device having a second input intended to receive a control signal defining the frequency of the radio-electric signal to be selected (CMD), a first output intended to supply a signal whose frequency, referred to as intermediate frequency, is fixed (FI), and a second output intended to supply a signal indicating that the radio frequency corresponds to the frequency defined by the control signal (SYNC), said device comprising:
- an oscillator (OSC) having a tuning input intended to receive a tuning signal, and an output intended to supply a signal whose frequency depends on the value of the tuning signal,
- a mixer (M) having a first input constituting the first input of the device and intended to receive the radio-electric signal, a second input connected to the output of the oscillator, and an output constituting the first output of the device and intended to supply a signal whose frequency is equal to the difference between the frequency of the signal received at the first input and that of the signal received at the second input,
- a frequency divider (DIV) having a first input connected to the output of the oscillator, a second input constituting the second input of the device, and an output intended to supply a signal whose frequency is equal to the frequency of the signal received at the first input, divided by a number defined by the control signal received at the second input,
- a phase detector (PD) having a first input intended to receive a reference signal having a fixed frequency, a second input connected to the output of the frequency divider, and an output connected to the input of the oscillator,
**characterized in that** the device also comprises means for generating a window signal (W) which is active during certain time intervals each including an active edge of the output signal of the frequency divider, and a flipflop (L) having a data input, a clock input and a data output, the data input being intended to receive the window signal, the clock input being intended to receive the reference signal, and the data output constituting the second output of the device.

2. A frequency-selection device as claimed in claim 1, **characterized in that** it comprises a digital low-pass filter (LPF) arranged between the data output of the flipflop and the second output of the device.

3. A frequency-selection device as claimed in claim 2, **characterized in that** the digital filter comprises:
- a modulo-M counter (CM) having a counting/initialization authorization input connected to the output of the flipflop, a clock input intended to receive the reference signal, and P outputs, with M = 2^{P}, an active level at the counting/initialization authorization input authorizing the counter to count, an inactive level setting each output of the counter at the inactive level,
- a detection module (DM) having P inputs connected to the P outputs of the counter, and an output constituting the second output of the device, intended to supply a signal which is set at the active level when all the outputs of the counter are at the active level and is maintained at this level until the counter receives an inactive level at its counting/initialization authorization input.

4. A frequency-selection device as claimed in any one of claim 1, 2 or 3, in which the frequency divider is composed of N elementary modules (EM1..EMN) arranged in cascade and each having a data input, a data output and a pulse output, the input of the first elementary module constituting the first input of the frequency divider, each elementary module being intended to operate a frequency division and to supply at its data output a signal resulting from this division and, at its pulse output, a signal which, during each period of the output signal of the frequency divider, is active during the first active state of the input signal, and inactive otherwise, **characterized in that**, if the output of the i^{th} elementary module, in which i may vary between 1 and N, is selected by means of the control signal received at the second input of the frequency divider for forming the output of said divider, the window signal is one of the signals supplied to the pulse output of one of the i first elementary modules.

5. A frequency-selection device as claimed in any one of claim 1, 2 or 3, in which the frequency divider comprises:
- N elementary modules (EM1..EMN) each having a data input intended to receive an input signal, and a data output intended to supply a signal having a frequency which is K times smaller than that of the signal received at its input, the output of an elementary module being connected to the input of the next elementary module, the input of the first elementary module constituting the first input of the frequency divider, the output of the N^{th} elementary module constituting the output of the frequency divider, each module also having a pulse output intended to supply a signal which, during each period of the output signal of the frequency divider, is active during the first active state of the input signal, and inactive otherwise,
- a decoder (D1) having an input constituting the second input of the frequency divider, and N outputs each defining the ratio K between the frequency of the input signal of an elementary module and that of its output signal,
**characterized in that** the window signal is one of the signals supplied by the pulse outputs (PLS) of the elementary modules.

6. A frequency-selection device as claimed in claim 5, **characterized in that** it comprises a multiplexer (M1) having N data inputs, a control input and a data output, each of the N data inputs being connected to the pulse output of one of the elementary modules of the frequency divider, the decoder having a supplementary output connected to the control input of the multiplexer enabling said multiplexer to supply a window signal at its output, which window signal is constituted by the signal supplied by the pulse output of the j^{th} elementary module, j varying between 1 and N as a function of the control signal.

7. A synchronism detector having a first input (Vco/R) intended to receive a first input signal, a second input (Vref) intended to receive a second input signal, and an output (SYNC), said detector comprising means for generating a window signal which is active during certain time intervals each including an active edge of the first input signal, and a flipflop (L) having a data input, a clock input and a data output, the data input being intended to receive the window signal, the clock input being intended to receive the second input signal, and the data output constituting the output of the synchronism detector.

8. A synchronism detector as claimed in claim 7, **characterized in that** it comprises a digital low-pass filter (LPF) arranged between the data output of the flipflop and the output of the synchronism detector.
